# EUROPEAN PATENT APPLICATION

(11) **EP 0 716 441 A2**
(43) Date of publication of application: **12.06.1996**
(21) Application number: 95119316.8
(22) Date of filing: 07.12.1995
(51) Int. Cl.: H01L 21/00

(54) **Substrate holding device and manufacturing method therefor**

(30) Priority: 08.12.1994 JP 331948/94
(71) Applicant: NISSIN ELECTRIC COMPANY, LIMITED, Ukyo-ku Kyoto-shi Kyoto (JP)
(72) Inventor: Orihara, Koichi, c/o Nissin Electric Co., Ltd., Kyoto-shi, Kyoto (JP); Ando, Yasunori, c/o Nissin Electric Co., Ltd., Kyoto-shi, Kyoto (JP); Inami, Hiroshi, c/o Nissin Electric Co., Ltd., Kyoto-shi, Kyoto (JP)
(74) Representative: Grünecker, Kinkeldey, Stockmair & Schwanhäusser Anwaltssozietät

(57) **Abstract**

A substrate holding device of the invention includes a base (4) cooled with a refrigerant, a flexible sheet (12) being extended on a surface of the base for forming a sealed portion between the sheet and the base, a refrigerant (18) with which the sealed portion is filled, a sheet-like rubber elastic substance (22) being disposed on the sheet, and a substrate retainer (20) for pressing fringes of a substrate placed on the rubber elastic substance against the base. Metal elastic members may be distributed almost uniformly in the sealed portion in place of or together with the rubber elastic substance.

## Description

### BACKGROUND OF THE INVENTION

### 1. Field of the Invention

This invention relates to a substrate holding device used when particles having energy such as ion beams, plasma, or electron beams are made incident on a substrate in a vacuum or any other atmosphere as in an ion implanter, an ion doping system (ion implanter of non-mass separation type), a sputtering system, a dry etching system, an electron beam irradiation system, etc., and more particularly to means for improving a cooling capability for the substrate.

### 2. Description of the Related Art

Various substrate holding devices have been proposed to suppress a temperature rise of a substrate caused by power input thereto by ion beams, plasma, etc., when treatment such as ion implantation or etching is applied to the surface of the substrate such as a semiconductor substrate or liquid crystal display glass substrate.

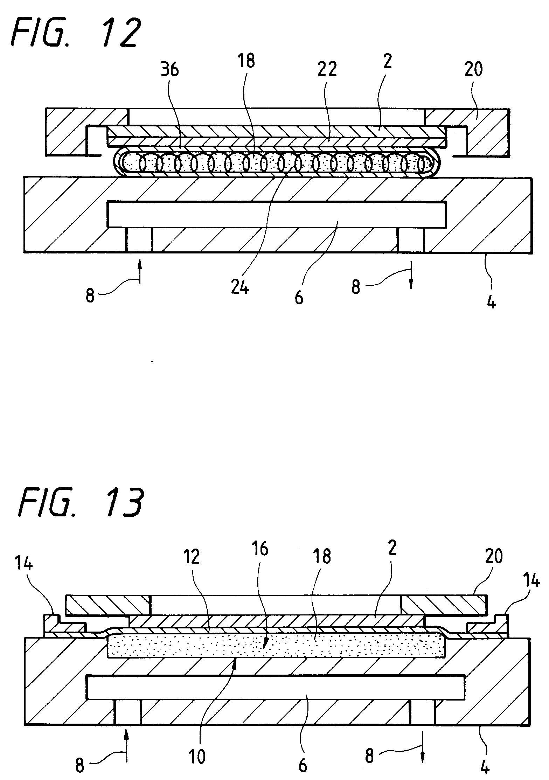

Fig. 13 shows one example of the conventional substrate holding devices. The substrate holding device is provided with a base 4 for supporting a substrate 2, etc., a flexible sheet 12 being extended so as to cover a recess 10 formed on the surface of the base 4 for forming a sealed portion between the sheet 12 and the base 4, a refrigerant 18 with which the sealed portion 16 is filled, and an annular substrate retainer 20 for pressing the fringes of the substrate 2 placed on the sheet 12 against the base 4. When the sealed portion 16 is filled with the refrigerant 18 so as to provide a proper pressure, the sheet 12 is swelled as shown in the drawing and even when the substrate 2 is pressed, remains swelled to a certain degree.

The sheet 12 is an extra-thin sheet made of, for example, fluororesin, polyimide, etc. The fringes of the sheet 12 are bonded to the base 4 for sealing and further pressed by means of a sheet retainer 14 for improving the fixation strength. The substrate 2 is pressed against the sheet 12 by the substrate retainer 20, whereby the sheet 12 comes in intimate contact with the rear face of the substrate 2.

In this example, the base 4 contains a refrigerant passage 6 into which a refrigerant 8, such as water or alternate chlorofluorocarbon, is caused to flow from the outside for cooling the base 4.

Necessary treatment is applied to the substrate 2 held by the substrate holding device in such a manner that the substrate 2 is irradiated with, for example, an ion beam through an opening of the substrate retainer 20 in a vacuum, for example. At the time, although heat input is applied to the substrate 2 by irradiation with the ion beam, etc., the heat flows into the base 4 via the sheet 12 and the refrigerant 18 from the substrate 2 and further is conveyed away by the refrigerant 8. The substrate 2 is thus cooled.

With the substrate holding device, the flexible sheet 12 is brought into intimate contact with the rear face of the substrate 2, whereby the contact area with the substrate 2 is increased as compared with the case where the substrate 2 is brought into direct contact with the base 4. Therefore, heat conduction from the substrate 2 to the base 4 can be improved. However, a substrate holding device having a higher cooling capability is desired from the viewpoint of furthermore lessening the temperature rise of the substrate 2.

### SUMMARY OF THE INVENTION

It is an object of the invention to provide a substrate holding device which is improved in thermal conduction from a substrate to a base for enhancing the cooling capability for the substrate, and a manufacturing method therefor.

A substrate holding device is comprised of a base for holding a substrate; a sealed portion provided on the base, at least part of the sealed portion being flexible; a refrigerant with which the sealed portion is filled; a sheet-shaped rubber elastic substance being disposed on sealed portion; and a substrate retainer for pressing fringes of the substrate placed on the substrate holding device against the base. Metal elastic members may be distributed almost uniformly in the sealed portion in place of or together with the rubber elastic substance.

The thermal conduction from the substrate to the base is improved and that the cooling capability for the substrate is improved by installing the rubber elastic substance as described above. Alternatively, the thermal conduction from the substrate to the base is improved and that the cooling capability for the substrate is improved by housing the metal elastic members in the sealed portion filled with the refrigerant as described above. If the rubber elastic substance and the metal elastic members are used together, both the thermal conduction between the base and the sheet and that in the refrigerant part them are improved, thus the thermal conduction between the substrate and the base is furthermore improved, improving the cooling capability for the substrate.

### BRIEF DESCRIPTION OF THE DRAWING

In the accompanying drawings:
Fig. 1 is a sectional view showing a substrate holding device according to a first embodiment of the invention;
Fig. 2 is a sectional view showing a substrate holding device according to a second embodiment of the invention;
Fig. 3 is a sectional view showing a substrate holding device according to a third embodiment of the invention;
Fig. 4 is a schematic plan view of the distribution state of elastic members in the embodiments shown in Figs. 2 and 3;
Fig. 5 is a sectional view to explain an example of a manufacturing method of the substrate holding device according to the invention;
Fig. 6 is a graph showing an example of the measurement results of temperature rise of a substrate;
Fig. 7 is a sectional view showing a substrate holding device according to a fourth embodiment of the invention;
Fig. 8 is a sectional view showing a substrate holding device according to a fifth embodiment of the invention;
Fig. 9 is a sectional view showing a substrate holding device according to a sixth embodiment of the invention;
Fig. 10 is a sectional view to explain another example of the manufacturing method of the substrate holding device according to the invention;
Fig. 11 is a graph showing another example of the measurement results of temperature rise of a substrate;
Fig. 12 is a sectional view showing a substrate holding device according to a seventh embodiment of the invention; and
Fig. 13 is a sectional view showing an example of a conventional substrate holding device.

### PREFERRED EMBODIMENTS OF THE INVENTION

Referring now to the accompanying drawings, preferred embodiments of the present invention will be described.

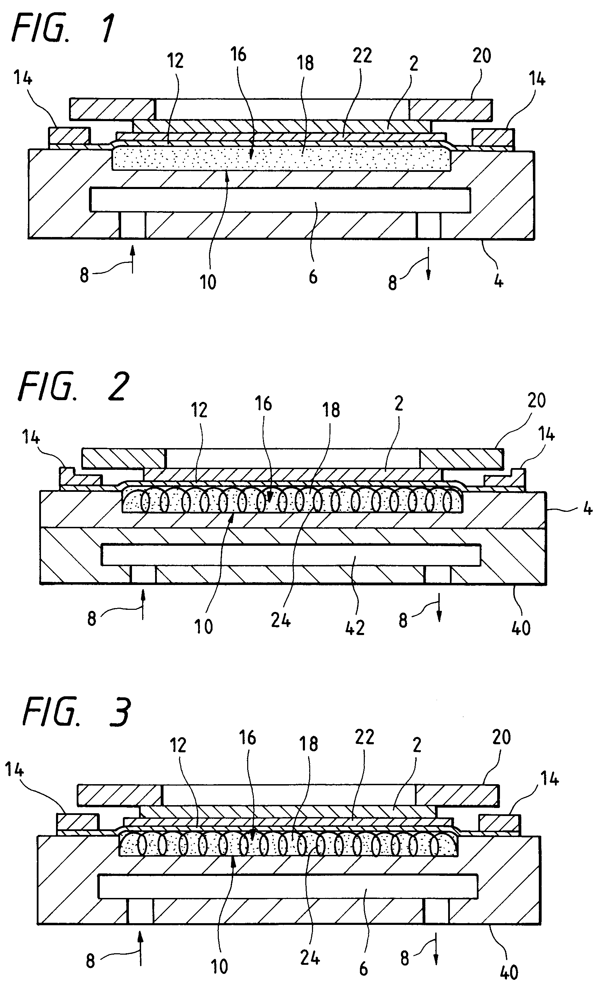

Fig. 1 is a sectional view showing a substrate holding device according to a first embodiment of the invention. Parts identical with or similar to those in the conventional example previously described with reference to Fig. 13 are represented by the same reference numerals in Fig. 1, and the differences between the first embodiment and the conventional example will be mainly discussed.

In the first embodiment, a rubber elastic substance 22 like a sheet is disposed on a sheet 12 as described above and a substrate 2 is pressed against a base 4, whereby the rubber elastic substance 22 is put between the substrate 2 and the sheet 12.

The rubber elastic substance 22 is made of silicone rubber, fluoro rubber, or rubber consisting essentially of them, for example.

To decrease thermal resistance at the rubber elastic substance 22 itself as much as possible, preferably the rubber elastic substance 22 is a substance having a high thermal conductivity as much as possible, for example, 1.5 W/m°C or more.

The rubber elastic substance 22 preferably is about in a range of 0.1 to 1 mm thick, more preferably 0.3 to 0.6 mm thick from the viewpoints of decreasing the thermal resistance at the rubber elastic substance 22 itself and maintaining the mechanical strength while maintaining the flexibility.

Preferably, the rubber elastic substance 22 is about 60-120 hard (JIS-A; the measurement method is according to JIS K 6301) because in higher hardness, the elasticity decreases and the effect of an increase in the contact area cannot be expected.

More specifically, preferably the rubber elastic substance 22 comprises a thermal-conductive filler blended with silicone rubber. For example, aluminum oxide, magnesium oxide, boron nitride, aluminum nitride, silicon nitride, etc., can be used as the thermal-conductive filler. In addition, to improve fire retardancy, one or more of aluminum hydroxide, platinum, platinum compound, graphite, etc., may also be added to the thermal-conductive filler. For reinforcement, the thermal-conductive filler may comprise glass cloth mixed in silicone rubber.

The sheet 12 may be a resin sheet made of fluororesin, polyimide, etc., as described above, preferably a metal sheet because of higher thermal conductivity, mechanical strength, and heat resistance.

Preferably, metal sheet material is stainless metal excellent in mechanical strength, heat resistance, corrosion resistance, etc. In addition, it may be titan, molybdenum, tantalum, tungsten, rhenium, indium, etc.

The metal sheet may be thick to such a degree that when the substrate 2 is pressed, the metal sheet can become deformed and is not broken; for example, it may be made in a range of 0.05 to 1 mm thick. However, the thickness of the sheet varies depending on the type of material used. For example, for SUS304, preferably the sheet is 0.1-0.3 mm thick.

Means such as bonding, fusion, and welding can be adopted for fixing the fringes of the sheet 12 to the base 4 for vacuum sealing. To enhance the fixation strength, these means may be used together with a sheet retainer 14 as in the example shown in Fig. 1, etc.

Preferably, liquid having a high thermal conductivity is used as a refrigerant 18 with which a sealed portion 16 is filled; for example, silicone oil, any other oil, grease, water, mercury, etc., can be used.

Since water has a higher thermal conductivity and a more excellent cooling capability than oil family, water, more specifically, pure water may be used as the refrigerant 18. However, if possible leakage in a vacuum atmosphere is considered, preferably silicone oil which is hard to evaporate in a vacuum and a little affects other vacuum systems is used as the refrigerant 18.

Preferably, the silicone oil has viscosity 300cs or less (at 25°C), for example.

Preferably, the liquid layer thickness of the refrigerant 18 is set to, for example, about in a range of 2 to 5 mm from the viewpoints of absorbing deformation of the sheet 12 and decreasing the thermal resistance in the refrigerant 18 itself.

The material of the substrate 2 to be processed may be glass, non-alkali glass used for amorphous silicon liquid crystal displays and polycrystalline silicon liquid crystal displays, low alkali glass (borosilicate glass) used for solar cell substrates, or silica glass or low expanded crystalline glass used for polycrystalline silicon color liquid crystal displays and further may be a semiconductor such as Si or GaAs.

The dimensions and thickness of the substrate 2 are not limited. The plane form of the substrate 2 can be a rectangle, a circle, or any other form. The plane forms of the sheet 12, the sealed portion 16, the rubber elastic substance 22, and the substrate retainer 20 may be determined in response to the form of the substrate 2.

The base 4 may be cooled directly with the refrigerant 8 as in the embodiment shown in Fig. 1 or may be cooled indirectly by locating a metal plate 40 cooled with the refrigerant 8 on the bottom face of the base 4 as shown in Fig. 2. Numeral 42 designates a refrigerant passage in Fig. 2. The refrigerant 8 is, for example, water, more specifically pure water, alternate chlorofluorocarbon, etc., as described above. However, how the base 4 is cooled does not affect the nature of the invention and is arbitrary.

The base 4 may be a thing for holding one substrate 2 like a platen or be something like a wafer disk for holding a plurality of substrates 2.

The substrate retainer 20 may be an annular form corresponding to the plane form of the substrate 2 or be a thing for pressing the fringes of the substrate 2 at a plurality of points.

For treating the substrate 2, the substrate holding device normally is used in a vacuum atmosphere, but may be used in any other atmosphere. When the substrate holding device is used in a vacuum atmosphere, the vacuum degree is not limited.

Treatment for the substrate 2 is, for example, ion implantation, ion doping (ion implantation of non-mass separation type), ion beam irradiation, plasma etching, sputter etching, ion beam etching, electron beam irradiation, etc. The ion and plasma types are not limited.

Although the sheet 12 is brought into intimate contact with the rear face of the substrate 2 as in the conventional example shown in Fig. 13, microscopically a large number of small gaps exist between the sheet 12 and the substrate 2 because of waves, wrinkles, asperities, etc., of the sheet 12 and the contact area between them is not much large. In contrast, if the rubber elastic substance 22 is put between the substrate 2 and the sheet 12 as in this embodiment, it conforms well with both the substrate 2 and the sheet 12, so that the gaps therebetween are filled and the contact area therebetween increases, whereby the thermal resistance between the substrate 2 and the sheet 12 decreases, improving thermal conduction and in turn improving the terminal conduction between the substrate 2 and the base 4. Resultantly, the cooling capability for the substrate 2 is improved.

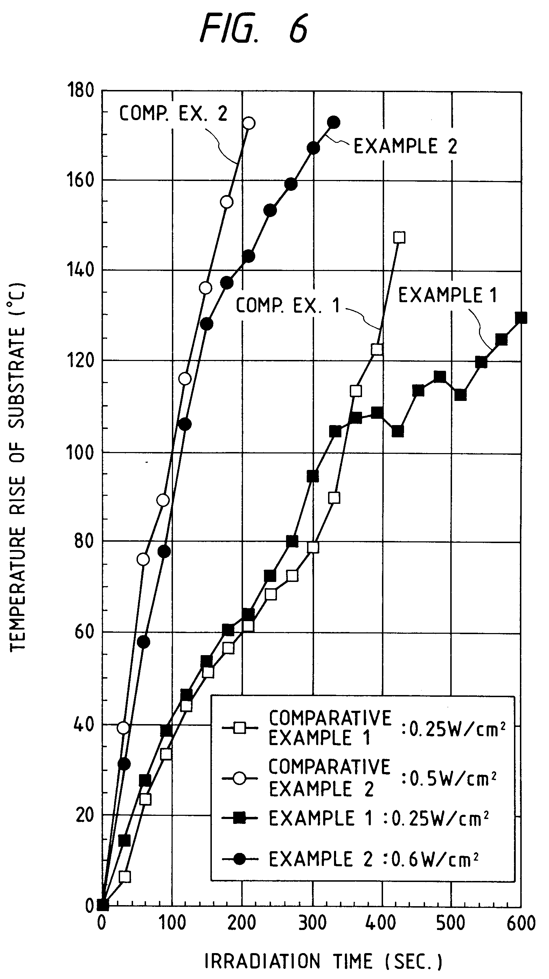

Fig. 6 shows the measurement results of the temperature rise of the substrate 2 when actual ion implantation into the substrate 2 is executed with the substrate holding device of the structure shown in Fig. 1.

The measurement conditions are as listed below:
- Substrate 2:: Material; Glass 7059 (trade name) manufactured by Corning Co., Ltd.
Dimensions; 300 mm x 300 mm x 1.1 mm
- Rubber elastic substance 22:: Material; Silicone rubber TC-45BG (trade name) manufactured by Shin-Etsu Kagaku Kogyo Co., Ltd.
Thickness; 0.45 mm
Hardness; JIS-A 90
- Sheet 12:: Material; SUS304
Thickness; 0.1 mm
- Refrigerant 18:: Material; Silicone oil SH200 (trade mark) manufactured by Tore Dow Corning Silicone Co., Ltd.)
Viscosity; 100 cs (at 25°C)
Liquid layer thickness; 3 mm
- Ion beam:: Nitrogen ions
- Vacuum degree of atmosphere:: 4.2 x 10⁻⁴ Torr
In Fig. 6, Examples 1 and 2 are examples in which the rubber elastic substance 22 is put as shown in Fig. 1 and input power to the substrate 2 by the ion beam in Example 1 is about 0.25 W/cm² and that in Example 2 is about 0.6 W/cm². Comparative Examples 1 and 2 are examples in which the rubber elastic substance 22 is not put as the conventional one and input power to the substrate 2 in Comparative Example 1 is about 0.25 W/cm² and that in Comparative Example 2 is about 0.5 W/cm². The input power slightly differs between Example 2 and Control Example 2 due to variations in adjustment.

When the input power is about 0.25 W/cm², the temperature of the substrate 2 rises almost to the same degree between Example 1 and Comparative Example 1 until about 350 seconds after the irradiation starts, but after the time, remarkably the temperature rise in Example 1 is more moderate than that in Comparative Example 1, and the temperature rise difference between Example 1 and Comparative Example 1 increases with the passage of time.

When the input power is about 0.5 W/cm², if it is considered that the input power in Example 2 is slightly larger than that in Comparative Example 2, the temperature of the substrate 2 rises almost to the some degree between Example 2 and Comparative Example 2 until about 150 seconds after the irradiation starts, but after the time, remarkably the temperature rise in Example 2 is more moderate than that in Comparative Example 2, and the temperature rise difference between Example 2 and Comparative Example 2 increases with the passage of time.

The reason why the temperature rise difference between Example and Comparative Example becomes remarkable after a lapse of the reasonable irradiation time, namely, heating time is that waves, wrinkles, or asperities of the sheet 12 become apparent as the substrate 2 is heated, worsening the thermal conduction obviously in the Comparative Examples in which no rubber elastic substance 21 is located.

The temperature rise difference between Example and Comparative Example becomes remarkable after a lapse of the reasonable irradiation time. It may be considered that waves, wrinkles or asperities of the sheet 12 become apparent accompanying with heat of the sheet 12, so that the thermal conduction in the Comparative Examples in which no rubber elastic substrate 21 is located are made worse.

According to the results, it can be confirmed that the rubber elastic substance 22 improves the cooling capability for the substrate 2.

In the treatment of the substrate 2, ion beams, etc., of comparatively large power may be used for short-time treatment or ion beams, etc., of comparatively small power may be used for long-time treatment. Thus, a sufficient effect is produced even if the effect of suppressing the temperature rise of the substrate 2 appears after a lapse of the reasonable time as in Examples 1 and 2.

Fig. 2 is a sectional view showing a substrate holding device according to a second embodiment of the present invention. The differences between the second embodiment and the first embodiment shown in Fig. 1 will be mainly discussed. In the second embodiment, in place of the rubber elastic substance 22 as described above, metal elastic members 24 are housed to be distributed almost uniformly in a sealed portion 16 between a sheet 12 and a base 4, more specifically in a plane of the sealed portion 16. The elastic members 24 come in contact with the faces above and below the elastic members 24, namely, the sheet 12 and the base 4 at least when a substrate is held.

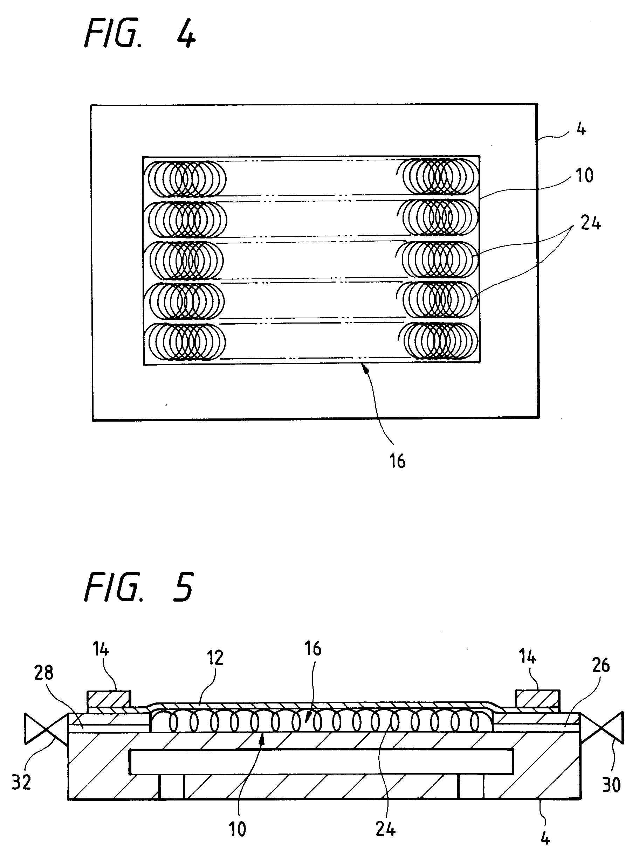

Fig. 4 shows a schematic example of the plane distribution state of the elastic members 24.

As shown in Fig. 4, each elastic member 24 is like an elongated coil spring comprising elastic metal small-gage wire, preferably extra-small metal small-gage wire wound a large number of times like a coil, and a plurality of the members are placed side by side almost uniformly in the sealed portion 16. In doing so, the elastic members can be easily distributed almost uniformly in the sealed portion 16.

In addition, the elastic members 24 may be a combination of metal small-gage wires like elongated coil springs such that they are distributed vertically and horizontally almost uniformly. The elastic members 24 may comprise metal small-gage wire wound a large number of times in a large number of directions and distributed almost uniformly. Each elastic member 24 may be like a coil spring with a short axial length (for example, several mm to 10 mm) and a plurality of them may be made upright and distributed almost uniformly in the plane of the sealed portion 16 so as to be expanded and contracted up and down.

Preferably, metal having a high thermal conductivity is used for the elastic members 24. More specifically, stainless material which is elastic and moreover excellent in mechanical strength, heat resistance, corrosion resistance, etc., is used for the elastic members 24. In addition, an alloy consisting essentially of copper may be used so that a higher thermal conductivity is provided.

If the metal elastic members 24 are distributed almost uniformly in the sealed portion 16, namely, the refrigerant 18 as in this embodiment, (1) since metal has a far higher thermal conductivity than the refrigerant 18, the thermal conductivity is improved as the entire refrigerant 18 part in the presence of such metal and moreover (2) when a substrate 2 is pressed against the sheet 12, the metal elastic members 24 are warped and come in direct contact with the faces above and below them, namely, the inner face of the sheet 12 and the top face of the base 4, thus providing thermal conduction via the metal elastic members 24. The effects (1) and (2) decrease the heat resistance of the refrigerant 18 part to improving the thermal conduction, thereby improving the terminal conduction between the substrate 2 and the base 4. Resultantly, the cooling capability for the substrate 2 is improved.

The rubber elastic substance 22 and metal elastic members 24 as described above may be used together as in a third embodiment shown in Fig. 3. Consequently, thermal conduction between a base 2 and a sheet 12 and that in the part of a refrigerant 18 below them are improved, thus the thermal conduction between the substrate 2 and a base 4 is furthermore improved, thereby improving the cooling capability for the substrate 2.

One embodiment of a manufacturing method of the substrate holding device shown in Fig. 2 or 3, particularly steps of forming a sealed portion 16 on the base 4 and inserting the refrigerant 18 and elastic members 24 therein will be explained as follows.

In Fig. 5, first, the elastic members 24 are placed on the base 4, more specifically, a recess 10 in the surface of the base in this embodiment. The recess 10 in which the elastic members 24 are placed is covered with the sheet 12. Then, the fringes of the sheet 12 are fixed to and sealed in the base 4 to form the sealed portion 16 therein.

Next, the sealed portion 16 is evacuated through a suction port 26 formed in the base 4. After the evacuation is continued for a predetermined time, while the evacuation is continued, the refrigerant 18 previously deaerated is injected into the sealed portion 16 through an injection port 28 formed in the base 4 for filling the region with the refrigerant 18, then the suction port 26 and the injection port 28 are closed. Specifically, in the example, valves 30 and 32 leading to the suction port 26 and the injection port 28 are closed.

According to the manufacturing method, easily the sealed portion 16 can be formed on the base 4 and the elastic members 24 can be housed in the region, which can be filled with the refrigerant 18.

When the substrate holding device shown in Fig. 1 is manufactured, the step of placing the elastic members 24 may be omitted in the manufacturing method as described above. That is, the sheet 12 is placed on the base 4, more specifically to cover a recess 10 in the surface of the base in this embodiment, the fringes of the sheet 12 are fixed to and sealed in the base 4, and the sealed portion 16 is formed therein.

Next, the sealed portion 16 is evacuated through a suction port 26. After the evacuation is continued for the required time, while the evacuation is continued, the refrigerant 18 previously deaerated is injected into the sealed portion 16 through an injection port 28 for filling the region with the refrigerant 18, then the suction port 26 and the injection port 28 are closed.

According to the manufacturing method, easily the sealed portion 16 can be formed on the base 4 and filled with the refrigerant 18.

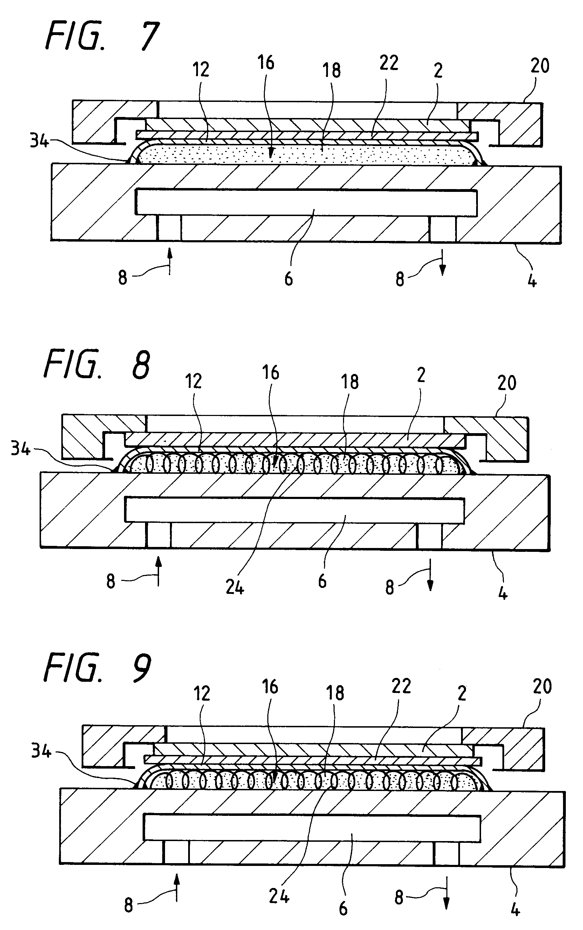

The surface of the base 4 need not necessarily be formed with the recess 10 as in the embodiments. Figs. 7 to 9 show fourth to sixth embodiments wherein the recess 10 is not formed. These embodiments correspond to the first to third embodiments shown in Figs. 1 to 3, respectively. The differences therebetween will be mainly discussed. In the fourth to sixth embodiments, a sheet 12 as described above is extended on the flat surface of a base 4 with a margin between the sheet 12 and the base 4 and the fringes of the sheet 12 are fixed to the surface of the base 4, thereby forming a sealed portion between the sheet 12 and the base 4. Numeral 34 represents the fixation part. Method for fixing the sheet 12 is, for example, bonding, fusion, welding, etc. The sealed portion 16 is filled with a refrigerant 18 as described above. When the sealed portion 16 is filled with the refrigerant 18 to provide a proper pressure, the sheet 12 is swelled as shown and when a substrate 2 is pressed, the swell is also held to some extent.

In the embodiment shown in Fig. 7, a rubber elastic substance 22 as described above is placed on the sheet 12. In the embodiment shown in Fig. 8, metal elastic members 24 as described above are housed in the sealed portion 16 so as to be distributed almost uniformly. In the embodiment shown in Fig. 9, a rubber elastic substance 22 and elastic members 24 are used together. An example of the distribution state of the elastic members 24 is similar to that shown above in Fig. 4.

In the embodiments in Figs. 7 to 9, similar effects to those discussed in the embodiments with reference to Figs. 1 to 3 can also be produced.

Fig. 11 shows the measurement results of the temperature rise of the substrate 2 when the substrate 2 is actually doped with ions using the substrate holding device shown in Fig. 8. The measurement conditions are as listed below:
- Substrate 2:: Glass substrate
- Sheet 12:: Material; SUS304
Thickness; 0.1 mm
- Refrigerant 18:: Material; Silicone oil
Liquid layer thickness; 2 mm
- Elastic member 24:: Material; SUS304
Form; Coil spring
In Fig. 11, Example 3 is an example in which the elastic members 24 are provided as shown in Fig. 8 and input power to the substrate 2 by an ion beam is about 0.46 W/cm². Comparative Example 3 is an example in which the elastic members 24 are not provided and input power to the substrate 2 is about 0.43 W/cm². The input power slightly differs between Example 3 and Control Example 3 due to variations in adjustment.

The temperature of the substrate 2 is almost the same in Example 3 and Comparative Example 3 until about 100 seconds after irradiation with the ion beam starts, but after the time, remarkably the temperature rise in Example 3 is more moderate than that in Comparative Example 3, and the temperature difference between Example 3 and Comparative Example 3 increases with the passage of time, and reaches not less than about 20°C. According to the results, it can be confirmed that the elastic members 24 improve the cooling capability for the substrate 2.

One embodiment of a manufacturing method of the substrate holding device shown in Fig. 8 or 9, particularly steps of forming a sealed portion 16 on the base 4 and inserting the refrigerant 18 and elastic members 24 therein is explained as follows.

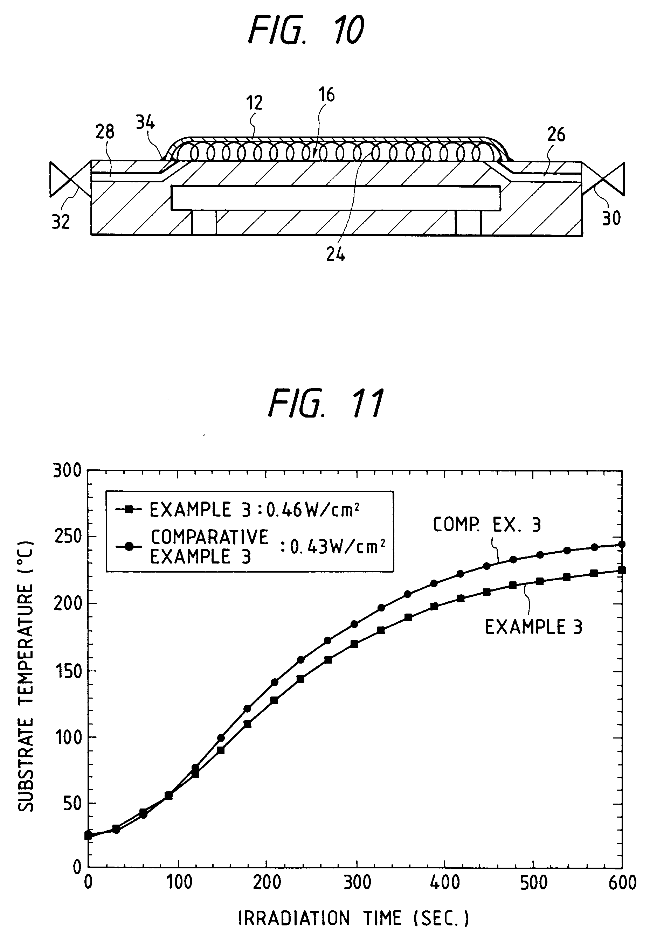

In Fig. 10, the elastic members 24 are placed on the base 4 and covered with the sheet 12, the fringes of the sheet 12 are fixed to and sealed in the base 4, and the sealed portion 16 is formed therein.

Next, the sealed portion 16 is evacuated through a suction port 26 made in the base 4. After the evacuation is continued for the required time, while the evacuation is continued, the refrigerant 18 previously deaerated is injected into the sealed portion 16 through an injection port 28 made in the base 4 for filling the region with the refrigerant 18, then the suction port 26 and the injection port 28 are closed. Specifically, in the example, valves 30 and 32 leading to the suction port 26 and the injection port 28 are closed.

According to the manufacturing method, easily the sealed portion 16 can be formed on the base 4 and the elastic members 24 can be housed in the region, which can be filled with the refrigerant 18.

When the substrate holding device shown in Fig. 7 is manufactured, the step of placing the elastic members 24 may be omitted in the manufacturing method as described above. That is, the sheet 12 is placed on the base 4, the fringes of the sheet 12 are fixed to and sealed in the base 4, and the sealed portion 16 is formed therein.

Next, the sealed portion 16 is evacuated through a suction port 26. After the evacuation is continued for the required time, while the evacuation is continued, the refrigerant 18 previously deaerated is injected into the sealed portion 16 through an injection port 28 for filling the region with the refrigerant 18, then the suction port 26 and the injection port 28 are closed.

According to the manufacturing method, easily the sealed portion 16 can be formed on the base 4 and filled with the refrigerant 18.

A bladder filled with a refrigerant 18 may be disposed on a base 4 instead of extending the sheet 12 on the base 4 and filling the sealed portion therebetween with the refrigerant 18 as in the embodiments discussed above. Fig. 12 shows such an embodiment as a seventh embodiment of the invention. The seventh embodiment corresponds to the embodiments shown in Figs. 3 and 9. The differences therebetween will be mainly discussed. In the seventh embodiment, a sealed bladder 36 made of a flexible sheet is disposed on a base 4; it is filled with a refrigerant 18 as described above. In the embodiment, metal elastic members 24 as described above are housed almost uniformly in the bladder 36, more specifically housed so as to be distributed almost uniformly in the plane of the bladder 36. Further, in the embodiment, a rubber elastic substance 22 as described above is disposed on the bladder 36 and a substrate 2 is pressed against the base 4 by a substrate retainer 20, thereby putting the rubber elastic substance 22 and the bladder 36 between the substrate 2 and the base 4.

Preferred examples of the material, thickness, etc., of the sheet forming the bladder 36 are similar to those of the sheet 12.

Preferred examples of the material and liquid layer thickness of the refrigerant 18, the material and thickness of the rubber elastic substance 22, and the material, form, layout, etc., of the elastic members 24 are as described above.

To house the refrigerant 18 and the elastic members 24 in the bladder 36, for example, a proper opening is mode in the bladder 36, the elastic members 24 are housed through the opening, further the refrigerant 18 deaerated is injected into the bladder 36, and last the opening is sealed.

Preferably, the bladder 36 is fixed on the base 4 with an adhesive, etc., so as not to slip out of place on the base 4.

The seventh embodiment also produces the effects substantially similar to those discussed above in the embodiments with reference to Figs. 3 and 9.

That is, when a substrate is held, the refrigerant 18 in the bladder 36 becomes deformed freely so as to provide an isotropic pressure. As a result, the refrigerant 18 can become uniformly thick in the plane of the substrate 2, thereby providing an even cooling capability.

Since the surface of the bladder 36 becomes deformed in response to asperities of the substrate 2 and the base 4, the contact area with the faces is large and therefore a large cooling capability is provided.

Moreover, if the rubber elastic substance 22 is put between the substrate 2 and the bladder 36, it conforms well with both the substrate 2 and the bladder 36. Accordingly, the gaps therebetween are filled and the contact area therebetween increases, and the thermal resistance between the substrate 2 and the bladder 36 decreases, thereby improving thermal conduction and in turn improving the terminal conduction between the substrate 2 and the base 4. As a result, the cooling capability for the substrate 2 is improved.

Further, if the metal elastic members 24 are distributed almost uniformly in the bladder 36, namely, the refrigerant 18, (1) since metal has a far higher thermal conductivity than the refrigerant 18, the thermal conductivity is improved as the entire refrigerant 18 part in the presence of such metal. Moreover, (2) when a substrate 2 is pressed against the bladder 36, etc., the metal elastic members 24 are warped and come in direct contact with the faces above and below them, namely, the top and bottom faces of the bladder 36, thus providing thermal conduction via the metal elastic members 24. The effects (1) and (2) decrease the heat resistance of the refrigerant 18 part to improve the thermal conduction, in turn improving the terminal conduction between the substrate 2 and the base 4. Resultantly, the cooling capability for the substrate 2 is improved.

Although the cooling capability is greatly improved by installing both the rubber elastic substance 22 and the elastic members 24 as in the embodiment, only either of them may be installed. That is, only the rubber elastic substance 22 may be installed without the elastic members 24, in which case the structure corresponds to that in the embodiment in Fig. 1 or 7. In this case, the above-mentioned effect produced by installing the rubber elastic substance 22 is produced. Only the elastic members 24 may be installed without the rubber elastic substance 22, in which case the structure corresponds to that in the embodiment in Fig. 2 or 8. In this case, the above-mentioned effect produced by installing the elastic members 24 is produced.

According to the substrate holding device, since the sheet-like rubber elastic substance is disposed on the sheet sealing a refrigerant and is put between the substrate and the sheet, it conforms well with both the substrate and the sheet, so that the gaps therebetween are filled and the contact area therebetween increases, whereby the thermal conduction between the substrate and the sheet is improved and in turn the terminal conduction between the substrate and the base is improved. Resultantly, the cooling capability for the substrate improved.

According to the substrate holding device, since the metal elastic members are housed so as to be distributed almost uniformly in the sealed portion filled a refrigerant and metal has a far higher thermal conductivity than the refrigerant, the thermal conductivity is improved as the entire refrigerant part in the presence of such metal. Moreover, when a substrate is pressed against the sheet, etc., the metal elastic members are warped and come in direct contact with the faces above and below them, namely, the inner face of the sheet and the top face of the base, thus providing thermal conduction via the metal elastic members. The two effects improve the thermal conduction in the refrigerant part and in turn improve the terminal conduction between the substrate and the base. Resultantly, the cooling capability for the substrate improved.

According to the substrate holding device, since the rubber elastic substance and the metal elastic members are used together, both the thermal conduction between the substrate and the sheet and that in the refrigerant part below them are improved. Resultantly, the thermal conduction between the substrate and the base is furthermore improved, improving the cooling capability for the substrate.

According to the substrate holding device, since the sheet-like rubber elastic substance is disposed on the bladder filled with a refrigerant and is put between the substrate and the bladder, it conforms well with both the substrate and the bladder, so that the gaps therebetween are filled and the contact area therebetween increases, whereby the thermal conduction between the substrate and the bladder is improved and in turn the terminal conduction between the substrate and the base is improved. Resultantly, the cooling capability for the substrate improved.

According to the substrate holding device, since the metal elastic members are housed so as to be distributed almost uniformly in the bladder filled with a refrigerant and metal has a far higher thermal conductivity than the refrigerant, the thermal conductivity is improved as the entire refrigerant part in the presence of such metal. Moreover, when a substrate is pressed against the bladder, etc., the metal elastic members are warped and come in direct contact with the faces above and below them, namely, the top and bottom faces of the bladder, thus providing thermal conduction via the metal elastic members. The two effects improve the thermal conduction in the refrigerant part and in turn improve the terminal conduction between the substrate and the base. Resultantly, the cooling capability for the substrate improved.

According to the substrate holding device, since the rubber elastic substance and the metal elastic members are used together, both the thermal conduction between the substrate and the bladder and that in the refrigerant part below them are improved. Resultantly, the thermal conduction between the substrate and the base is furthermore improved, improving the cooling capability for the substrate.

According to the substrate holding device, the metal elastic members, each of which comprises elastic metal small-gage wire wound a large number of times like a coil, can be easily distributed almost uniformly in the sealed portion or the bladder.

According to the manufacturing method, a sealed portion can be easily formed on the base and filled with a refrigerant.

According to the manufacturing method, a sealed portion can be easily formed on the base and the elastic members can be housed therein and the sealed portion can be filled with a refrigerant.

## Claims

1. A substrate holding device comprising:
a base for holding a substrate;
a sealed portion provided on said base, at least part of said sealed portion being flexible;
a refrigerant with which said sealed portion is filled;
a sheet-shaped rubber elastic substance being disposed on sealed portion; and
a substrate retainer for pressing fringes of said substrate placed on said substrate holding device against said base.

2. A substrate holding device according to claim 1, further comprising a flexible sheet whose fringe is extended on a surface of said base to form said sealed portion between said sheet and said base.

3. A substrate holding device according to claim 2 further comprising metal elastic members being housed to be distributed substantially uniformly in said sealed portion.

4. A substrate holding device according to claim 3, wherein said elastic members comprise elastic metal small-gage wire wound a large number of times like a coil and a plurality of said members are placed side by side substantially uniformly.

5. A substrate holding device according to claim 1, wherein said sheet-shaped rubber elastic substance has a thermal conductivity equal to 1.5 W/m°C or more.

6. A substrate holding device according to claim 1, wherein said sheet-shaped rubber elastic substance has a thickness in a range of 0.1mm to 1.0mm.

7. A substrate holding device according to claim 6, wherein said sheet-shaped rubber elastic substance has a thickness in a range of 0.3mm to 0.6mm.

8. A substrate holding device according to claim 1, wherein said sheet-shaped rubber elastic substance has a hardness in a range of 60 to 120 (JIS-A; the measurement method is according to JIS K 6301).

9. A substrate holding device according to claim 1, further comprising metal elastic members being housed to be distributed substantially uniformly in said sealed portion.

10. A substrate holding device according to claim 9, wherein said elastic members comprise elastic metal small-gage wire wound a large number of times like a coil and a plurality of said members are placed side by side substantially uniformly.

11. A substrate holding device according to claim 1, further comprising a flexible bladder to form said sealed portion.

12. A substrate holding device according to claim 11, further comprising metal elastic members being housed to be distributed substantially uniformly in said bladder.

13. A substrate holding device according to claim 12, wherein said elastic members comprise elastic metal small-gage wire wound a large number of times like a coil and a plurality of said members are placed side by side substantially uniformly.

14. A substrate holding device comprising:
a base for holding a substrate;
a sealed portion provided on said base, at least part of said sealed portion being flexible;
a refrigerant with which said sealed portion is filled;
metal elastic members being housed to be distributed substantially uniformly in said sealed portion; and
a substrate retainer for pressing fringes of said substrate placed on said substrate holding device against said base.

15. A substrate holding device according to claim 14, further comprising a flexible sheet whose fringe is extended on a surface of said base to form said sealed portion between said sheet and said base.

16. A substrate holding device according to claim 14, further comprising a flexible bladder to form said sealed portion.

17. A substrate holding device according to claim 14, further comprising a sheet-shaped rubber elastic substance being disposed on sealed portion.

18. A method of manufacturing a substrate holding device comprising the steps of:
placing a sheet on a base for holding a substrate;
fixing fringes of said sheet to said base to form a sealed portion therein;
while evacuating said sealed portion through a suction port formed in said base, injecting a previously deaerated refrigerant into said sealed portion through an injection port formed in said base to filling said sealed portion with a refrigerant; and
closing said suction port and said injection port.

19. A method according to claim 18, wherein a metal elastic members are placed on said base, and said elastic members are covered with said sheet.
